# EUROPÄISCHE PATENTSCHRIFT

(11) **EP 1 654 547 B1**
(45) Veröffentlichungstag und Bekanntmachung des Hinweises auf die Patenterteilung: **14.09.2011**
(21) Anmeldenummer: 04763214.6
(22) Anmeldetag: 14.07.2004
(51) Int. Cl.: G01R 19/165

(54) **VERFAHREN UND SCHALTUNGSANORDNUNG ZUR ÜBERWACHUNG DER FUNKTIONSWEISE EINES ODER MEHRERER VERBRAUCHERSTROMKREISE, INSBESONDERE EINES HAUSGERÄTS**
METHOD AND CIRCUIT ARRANGEMENT FOR MONITORING THE MODE OF OPERATION OF ONE OR MORE LOAD CIRCUITS, ESPECIALLY OF A DOMESTIC APPLIANCE
PROCEDE ET CIRCUIT POUR LA SUPERVISION DU MODE DE FONCTIONNEMENT D'UN OU DE PLUSIEURS CIRCUITS UTILISATEURS, EN PARTICULIER D'UN APPAREIL MÉNAGER

(30) Priorität: 08.08.2003 DE 10336604
(43) Veröffentlichungstag der Anmeldung: 10.05.2006
(73) Patentinhaber: BSH Bosch und Siemens Hausgeräte GmbH, 81739 München (DE)
(72) Erfinder: DUSCHER, Christian, 93152 Undorf (DE)
(86) Internationale Anmeldenummer: PCT/EP2004/007789
(87) Internationale Veröffentlichungsnummer: WO 2005/017541

(56) Entgegenhaltungen:
- DE-A- 2 150 888
- US-A- 4 109 308
- US-A- 4 464 661
- DATABASE WPI Section EI, Week 198213 Derwent Publications Ltd., London, GB; Class S01, AN 1982-D6610E XP002306120 & SU 840 747 B (NOVOS ELECTROTECH) 24. Juni 1981 (1981-06-24)

## Beschreibung

Die Erfindung bezieht sich auf ein Verfahren und eine Schaltungsanordnung zur Überwachung der Funktionsweise eines oder mehrerer Verbraucherstromkreise, insbesondere eines Hausgeräts, die jeweils einen steuerbaren Halbleiterschalter, insbesondere einen Triac, und einen mit diesem verbundenen elektrischen Verbraucher enthalten und die von wenigstens einer Wechselspannungsquelle gespeist werden, welche eine Wechselspannung mit positiven und negativen Spannungshalbwellen liefert.

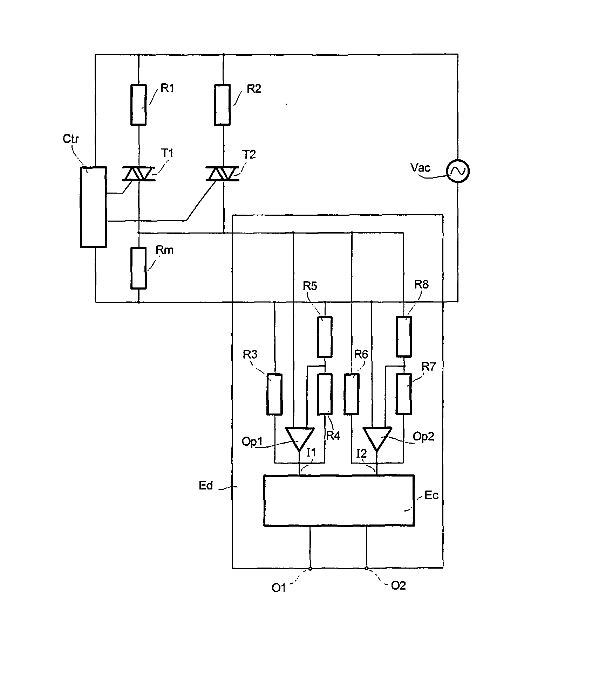

Zur Überwachung der Funktionsweise eines einen Gleichstrommotor enthaltenden Verbraucherstromkreises ist es bereits bekannt (siehe beispielsweise Siemens Schaltbeispiele, Ausgabe 1982/83, Seite 37, Bild 2.2 und Seite 47, Bild 2.5), den Stromfluss im Verbraucherstromkreis über einen niederohmigen Messwiderstand (Shuntwiderstand zu leiten und den Spannungsabfall an diesem Messwiderstand mittels eines Operationsverstärkers auszuwerten. Eine Überwachung der Funktionsweise eines oder mehrerer Verbraucherstromkreise, die von wenigstens einer Wechselspannungsquelle gespeist werden, also nicht eine Gleichspannung zugeführt erhalten, ist in dem betrachteten Zusammenhang indessen nicht bekannt.

Der Erfindung liegt daher die Aufgabe zugrunde, einen Weg zu zeigen, wie auf relativ einfache Weise die Funktionsweise eines oder mehrerer Verbraucherstromkreis überwacht werden kann, die von wenigstens einer Wechselspannungsquelle gespeist werden.

Gelöst wird die vorstehend aufgezeigte Aufgabe bei einem Verfahren der eingangs genannten Art erfindungsgemäß nach Anspruch 1.

Die vorliegende Erfindung nutzt zwar wie der oben betrachtete Stand der Technik die Verwendung eines niederohmigen Messwiderstands aus, allerdings ist hier lediglich ein einziger niederohmiger Messwiderstand für sämtliche vorhandenen Verbraucherstromkreise vorgesehen. Außerdem werden bei der vorliegenden Erfindung die an dem verwendeten einzigen niederohmigen Messwiderstand jeweils auftretenden positiven und negativen Spannungsabfälle gesondert ausgewertet, welche auf die Stromflüsse durch sämtliche überwachten Verbraucherstromkreise zurückgehen. Dadurch lassen sich bei fehlerhaftem Arbeiten eines oder mehrerer der vorhandenen Verbraucherstromkreise in vorteilhafter Weise Rückschlüsse auf unterschiedliche Fehler in den betreffenden Verbraucherstromkreisen ziehen, je nachdem ob und gegebenenfalls welche der positiven und/oder negativen Spannungsabfälle an dem genannten einzigen niederohmigen Messwiderstand von vorgegebenen Nennwerten gleichen. So lässt sich beispielsweise aus einem Anstieg der positiven und der negativen Spannungsabfälle an dem genannten einzigen Messwiderstand über vorgegebene Nennwerte hinaus im Falle eines einen elektrischen Verbraucher darstellenden Elektromotors, wie eines Pumpenmotors eines Hausgeräts, ableiten, dass dieser Motor nicht ordnungsgemäß läuft. Im Falle eines von einem vorgegebenen Nennwert abweichenden positiven oder negativen Spannungsabfalls an dem genannten einzigen niederohmigen Messwiderstand kann zum Beispiel eine fehlerhafte Funktionsweise eines oder mehrerer der vorhandenen steuerbaren Halbleiterschalter erkannt werden. Dies führt zu einer Eingrenzung möglicher fehlerhafter Teile der überwachten Verbraucherstromkreise.

Zur Durchführung des Verfahrens gemäß der Erfindung dient eine Schaltungsanordnung nach Anspruch 2.

Zweckmäßigerweise weist die Auswerteanordnung eine die positiven Spannungshalbwellen der betreffenden Wechselspannung auswertende erste Auswerteeinrichtung und eine die negativen Spannungshalbwellen der betreffenden Wechselspannung auswertende zweite Auswerteeinrichtung auf. Hierdurch ergibt sich der Vorteil einer besonders einfach aufzubauenden Auswerteanordnung.

Ein besonders geringer schaltungstechnischer Aufwand ergibt sich in vorteilhafter Weise dadurch, dass jede der beiden Auswerteeinrichtungen durch einen Operationsverstärker gebildet ist, der mit seinem invertierenden Eingang und mit seinem nichtinvertierenden Eingang an den beiden Enden des genannten niederohmigen Messwiderstands angeschlossen ist.

Dabei sind zweckmäßigerweise ein erster Operationsverstärker mit seinem nichtinvertierenden Eingang und ein zweiter Operationsverstärker mit seinem invertierenden Eingang mit dem einen Ende des genannten Messwiderstands verbunden, und es sind der genannte erste Operationsverstärker mit seinem invertierenden Eingang und der genannte zweite Operationsverstärker mit seinem invertierenden Eingang mit dem anderen Ende des genannten Messwiderstands verbunden. Durch diese schaltungstechnische Maßnahme können die beiden genannten Operationsverstärker auf besonders einfache Weise Spannungshalbwellen unterschiedlicher Polarität der an dem genannten Messwiderstand jeweils abfallenden Wechselspannung auswerten.

Gemäß einer noch weiteren zweckmäßigen Ausgestaltung der vorliegenden Erfindung ist mit den Ausgängen der beiden Operationsverstärker eine Auswerteschaltung verbunden, welche die von den beiden Operationsverstärkern jeweils abgegebenen Ausgangssignale mit festgelegten Schwellwertspannungen vergleicht und welche in Abhängigkeit von der Größe des Über- oder Unterschreitens der genannten festgelegten Schwellwertspannungen durch die von den betreffenden Operationsverstärkern jeweils abgegebenen Ausgangsspannungen Meldesignale abgibt, die entweder einen ordnungsgemäßen Stromfluss oder einen gestörten Stromfluss durch wenigstens einen der vorhandenen elektrischen Verbraucher und den mit diesem verbundenen gesteuerten Halbleiterschalter anzeigen. Hierdurch ergibt sich der Vorteil eines besonders geringen schaltungstechnischen Aufwands für den Aufbau der genannten Auswerteschaltung; diese Auswerteschaltung kommt nämlich im Prinzip mit zwei Spannungsvergleichern aus.

Anhand einer Zeichnung werden nachstehend das Verfahren und die Schaltungsanordnung gemäß der Erfindung näher erläutert.

In der Zeichnung ist ein Ausführungsbeispiel einer Schaltungsanordnung gemäß der vorliegenden Erfindung dargestellt. Die betreffende Schaltungsanordnung dient im vorliegenden Fall zur Überwachung der Funktionsweise von zwei Verbraucherstromkreisen, die insbesondere in einem Hausgerät, wie einer Waschmaschine, einem Geschirrspüler, einem Trockner, etc. vorgesehen sein können. Von den beiden dargestellten Verbraucherstromkreisen umfasst der eine einen elektrischen Verbraucher R1, und der andere umfasst einen elektrischen Verbraucher R2. Diese elektrischen Verbraucher R1, R2 können beispielsweise elektrische Motoren oder Heizwiderstände sein. Die beiden dargestellten elektrischen Verbraucher R1 und R2 sind jeweils mit einem steuerbaren Halbleiterschalter T1 bzw. T2 in Reihe geschaltet, und zwar mit der Laststrecke des jeweiligen Halbleiterschalters T1 bzw. T2. Die betreffenden steuerbaren Halbleiterschalter sind im vorliegenden Fall durch Triacs gebildet, deren Steuerelektroden mit nicht näher bezeichneten Steuerausgängen einer Steuerschaltung Ctr verbunden sind, die von einer in der Zeichnung angedeuteten Wechselspannungsquelle Vac gespeist wird. Anstelle der vorstehend erwähnten Triacs können aber durchaus auch andere steuerbare Halbleiterschalter verwendet werden, wie Thyristoren, Leistungstransistoren, wie sogenannte Power-MOSFETS, etc.

Sämtliche vorgesehenen steuerbaren Halbleiterschalter T1, T2 und die mit diesen verbundenen elektrischen Verbraucher R1 bzw. R2 sind gemeinsam über einen niederohmigen Messwiderstand Rm an der Wechselspannungsquelle Vac angeschlossen, die eine Wechselspannung mit positiven und negativen Spannungshalbwellen liefert und die beispielsweise die übliche Netzwechselspannung von 230V, 50Hz sein kann.

Grundsätzlich ist es jedoch möglich, für jeden der vorhandenen Verbraucherstromkreise eine eigene Wechselspannungsquelle vorzusehen.

An dem niederohmigen Messwiderstand Rm, dessen Widerstandswert von der Höhe der maximal zu erwartenden fließenden Ströme abhängt und der einen Wert von beispielsweise 0,1 Ohm besitzen kann, ist eine die positiven und die negativen Spannungshalbwellen der an diesem Messwiderstand abfallenden Wechselspannung gesondert auswertende Auswerteanordnung Ed angeschlossen. Diese Auswerteanordnung Ed umfasst zwei Auswerteeinrichtungen in Form jeweils eines Operationsverstärkers Op1, Op2.

Der als erster Operationsverstärker zu bezeichnende Operationsverstärker Op1 ist mit seinem nichtinvertierenden Eingang (+) am gemeinsamen Verbindungspunkt der Triacs T1, T2 und des niederohmigen Messwiderstands Rm angeschlossen, und er ist mit seinem invertierenden Eingang (-) über einen Widerstand R5 am anderen Ende des Messwiderstands Rm angeschlossen. Mit diesem anderen Ende des Messwiderstands Rm, der gegebenenfalls geerdet sein bzw. auf Massepotential liegen kann, ist ferner der Ausgang des ersten Operationsverstärkers Op1 über einen Widerstand R3 angeschlossen. Der betreffende Ausgang des ersten Operationsverstärkers Op1 ist außerdem über einen Widerstand R4 mit dessen invertierenden Eingang (-) verbunden.

Der als zweiter Operationsvertärker zu bezeichnende Operationsverstärker Op2, der im übrigen vom selben Operationsverstärkertyp sein kann bzw. ist wie der erste Operationsverstärker Op1, ist mit seinem invertierenden Eingang (-) über einen Widerstand R8 am gemeinsamen Verbindungspunkt der Triacs T1, T2 und des niederohmigen Messwiderstands Rm angeschlossen. Der nichtinvertierende Eingang (+) des zweiten Operationsverstärkers Op2 ist mit dem anderen Ende des niederohmigen Messwiderstands Rm verbunden. Der Ausgang des zweiten Operationsverstärkers Op2 ist zum einen über einen Widerstand R6 an dem gemeinsamen Verbindungspunkt der Triacs T1, T2 und des niederohmigen Messwiderstands Rm angeschlossen, und er ist zum anderen über einen Widerstand R7 mit seinem invertierenden Eingang (-) verbunden.

Im Hinblick auf die beiden vorstehend betrachteten Operationsverstärker Op1, Op2 ist noch anzumerken, dass die für diese Operationsverstärker erforderlichen Versorgungsspannungsquellen und deren Verbindung mit den betreffenden Operationsverstärkern hier nicht dargestellt sind, da dies nichts mit der vorliegenden Erfindung als solcher zu tun hat.

Aufgrund der vorstehend erläuterten Art des Anschlusses der beiden Operationsverstärker Op1, Op2 mit ihren nichtinvertierenden Eingängen (+) und invertierenden Eingängen (-) an dem niederohmigen Messwiderstand Rm ergibt sich, dass der erste Operationsverstärker Op1 als nichtinvertierender Verstärker arbeitet und die positiven Halbwellen der an dem niederohmigen Messwiderstand Rm jeweils abfallenden Spannung auswertet. Demgegenüber arbeitet der zweite Operationsverstärker Op2 als invertierender Verstärker, der die negativen Halbwellen der an dem niederohmigen Messwiderstand Rm jeweils abfallenden Spannung auswertet.

Die auf diese Weise von den Ausgängen der beiden Operationsverstärker Op1, Op2 jeweils abgegebenen Ausgangssignale werden im Falle des ersten Operationsverstärkers Op1 einem Eingang I1 einer Auswerteschaltung Ec und im Falle des zweiten Operationsverstärkers Op2 einem Eingang I2 der betreffenden Auswerteschaltung Ec zugeführt. Diese Auswerteschaltung vergleicht die betreffenden Ausgangssignale mit festgelegten Schwellwertspannungen und kann in Abhängigkeit von der Größe des Über- oder Unterschreitens der betreffenden Schwellwertspannungen durch die von den genannten Operationsverstärkern Op1, Op2 jeweils abgegebenen Ausgangssignale an Ausgängen 01 bzw. 02 Meldesignale abgeben, die entweder einen ordnungsgemäßen Stromfluss oder einen gestörten Stromfluss durch den jeweiligen Verbraucherstromkreis anzeigen, umfassend im vorliegenden Fall zum einen den elektrischen Verbraucher R1 und den mit diesem in Reihe liegenden Triac T1 und zum anderen den elektrischen Verbraucher R2 und den dazu in Reihe liegenden Triac T2 mit seiner Hauptlaststrecke.

Bei der vorstehend betrachteten Arbeitsweise der in der Zeichnung dargestellten Verbraucherstromkreise ist davon ausgegangen worden, dass diese alle gleichzeitig in Betrieb sind. In diesem Falle gibt ein einen gestörten Stromfluss anzeigendes Meldesignal, das an einem der Ausgänge 01, 02 beispielsweise mit einem hohen Pegel auftritt, an, dass in wenigstens einem der betreffenden Verbraucherstromkreise ein Fehler vorliegt. In diesem Falle sind die zuvor erwähnten Schwellwertspannungen entsprechend dem Gesamtbetrieb aller Verbraucherstromkreise festgelegt. Ein Meldesignal, das beispielsweise mit einem niedrigen Pegel auftritt, würde dann einen ordnungsgemäßen Betrieb der erfassten Verbraucherstromkreise anzeigen.

Prinzipiell ist es jedoch auch möglich, dass die insgesamt vorhandenen Verbraucherstromkreise in Gruppen mit jeweils mehreren Verbraucherstromkreisen aufgeteilt werden und dass die zu jeweils einer solchen Verbraucherstromkreisgruppe gehörenden Verbraucherstromkreise gleichzeitig in Betrieb gesetzt werden. In diesem Falle wären dann in der Auswerteschaltung Ec beispielsweise den Strom-Normalwerten der jeweiligen Verbraucherstromkreisgruppe entsprechende Schwellwertspannungen bereitzustellen. Dies heißt, dass zwischen der Abgabe von Steuersignalen von der Steuereinrichtung Ctr und der Bereitstellung der jeweils zugehörigen Schwellwertspannungen in der Auswerteschaltung Ec eine entsprechende Synchronisierung hergestellt werden muss. Diese Synchronisierung kann beispielsweise durch eine synchrone Umschaltung in der Steuersignalabgabe und der Schwellwertspannungsbereitstellung erfolgen.

Um festzustellen, welcher einzelne der Verbraucherstromkreise fehlerhaft arbeitet, ist die vorstehend erwähnte Synchronisierung zwischen der Abgabe von Steuersignalen von der Steuereinrichtung Ctr und der Bereitstellung der jeweils zugehörigen Schwellwertspannungen in der Auswerteschaltung Ec auf jeden einzelnen Verbraucherstromkreis auszuweiten. Dazu werden zum einen die steuerbaren Halbleiterschalter der vorhandenen Verbraucherstromkreise einzeln nacheinander aktiviert, und zum anderen werden in der Auswerteschaltung Ec den betreffenden Verbraucherstromkreisen individuell zugehörige Schwellwertspannungen bereitgestellt. Die dadurch ermittelten Meldesignale sind dann den betreffenden Verbraucherstromkreisen individuell zugeordnet, wodurch sich eine schnelle Fehlereingrenzung erreichen lässt.

Durch die zuvor erwähnten Meldesignale kann beispielsweise in dem Fall, dass ein elektrischer Verbraucher durch eine Umwälzpumpe ohne gesonderte Tachorückmeldung gebildet ist, bezogen auf einen vorgegebenen Nennwert ein zu hoher Stromfluss erkannt und daraus abgeleitet werden, dass die betreffende Umwälzpumpe blockiert ist, woraufhin der Stromkreis der betreffenden Umwälzpumpe sofort abgeschaltet werden kann. Dies bedeutet, dass der im Laststromkreis dieses elektrischen Verbrauchers liegende steuerbare Halbleiterschalter leistungsschwächer und mit kleinerer Kühlfläche als in dem Fall dimensioniert sein kann, dass eine solche Abschaltung mangels entsprechender Überwachung nicht sofort erfolgen kann.

Überdies lässt sich die durch die erläuterte Auswerteanordnung Ed vorgenommene Überwachung der Funktionsweise der jeweils vorgesehenen Verbraucherstromkreise beispielsweise durch eine Klartextanzeige oder durch eine 7-Segment-Anzeige mittels entsprechender Anzeigeeinrichtungen darstellen, was bei gestörter Funktionsweise der betreffenden Verbraucherstromkreise zu einer vereinfachten und schnelleren Fehlerfindung führen kann. In diesem Zusammenhang ist auch eine Anzeige darüber vornehmbar, dass kein Fehler feststellbar ist bzw. dass die Verbraucherstromkreise ordnungsgemäß funktionieren. Derartige Anzeigen könnten auch einem Kundendienst durch Fernabfrage verfügbar gemacht werden, um vorab Diagnosen stellen zu können. In jedem Falle ist durch die vorliegende Erfindung eine vereinfachte und schnellere Fehlerfindung im Falle des fehlerhaften Arbeitens eines oder mehrerer der vorhandenen Verbraucherstromkreise ermöglicht.

Außerdem lassen sich durch die vorliegende Erfindung ein Dauerbetrieb (Vollwellenbetrieb) und ein Halbwellenbetrieb im jeweiligen Verbraucherstromkreis auf einfache Weise erkennen. Dabei ist das Erkennen eines ständigen Halbwellenbetriebs insbesondere bei Verwendung von Pumpenmotoren als elektrische Verbraucher wichtig, da diese Pumpenmotoren bei ständigem Halbwellenbetrieb zerstört werden. Abhilfe schafft hier eine Vollwellensteuerung der betreffenden Motoren verbunden mit der Ausgabe eines entsprechenden Warnhinweises und der zunächst möglichen Abschaltung der betreffenden Pumpenmotoren. Dies kann durch die vorliegende Erfindung sichergestellt werden.

Abschließend sei noch angemerkt, dass die vorliegende Erfindung zuvor im Zusammenhang mit der Überwachung der Funktionsweise von zwei Verbraucherstromkreisen erläutert worden ist. Die Erfindung ist jedoch darauf nicht beschränkt; sie kann vielmehr zur Überwachung der Funktionsweise wenigstens eines Verbraucherstromkreises, aber auch zur Überwachung der Funktionsweise von mehr als zwei Verbraucherstromkreisen herangezogen werden.

## Patentansprüche

1. Verfahren zur Überwachung der Funktionsweise eines oder mehrerer Verbraucherstromkreise, insbesondere eines Hausgeräts, die jeweils einen steuerbaren Halbleiterschalter, insbesondere einen Triac, und einen mit diesem verbundenen elektrischen Verbraucher enthalten und die von wenigstens einer Wechselspannungsquelle gespeist werden, welche eine Wechselspannung mit positiven und negativen Spannungshalbwellen liefert, **dadurch gekennzeichnet, dass** die sämtliche steuerbaren Halbleiterschalter (T1, T2) und elektrischen Verbraucher (R1, R2) durchfließenden Wechselströme durch einen gemeinsamen niederohmigen Messwiderstand (Rm) geleitet werden und dass der an diesem niederohmigen Messwiderstand (Rm) jeweils auftretende Wechselspannungsabfall hinsichtlich der Amplituden der positiven und der negativen Wechselspannungshalbwellen gesondert ausgewertet wird.

2. Schaltungsanordnung zur Durchführung des Verfahrens nach Anspruch 1, insbesondere für ein Hausgerät, wobei die Schaltungsanordnung
- einen oder mehrere Verbraucherstromkreise aufweist die jeweils einen steuerbaren Halbleiterschalter, insbesondere einen Triac, und einen mit diesem verbundenen elektrischen Verbraucher enthalten, und wobei die Schaltungsanordnung
- wenigstens eine Wechselspannungsquelle zum Speisen der Verbraucherstromkreise aufweist, wobei die Wechselspannungsquelle eine Wechselspannung mit positiven und negativen Spannungshalbwellen liefert,
**dadurch gekennzeichnet, dass**
die Schaltungsanordnung einen gemeinsamen niederohmigen Messwiderstand (Rm) aufweist, über welchen die elektrischen Verbraucher (R1, R2) zusammen mit ihren zugehörigen steuerbaren Halbleiterschaltern (T1, T2) an der wenigstens einen Wechselspannungsquelle (Vac) angeschlossen sind, wobei die Schaltungsanordnung auch eine Auswerteanordnung (Ed) aufweist, die an dem gemeinsamen niederohmigen Messwiderstand (Rm) angeschlossen ist und die dazu ausgebildet ist, die Amplituden der positiven und der negativen Spannungshalbwellen eines Wechselspannungsabfalls an dem Messwiderstand (Rm) gesondert auszuwerten.

3. Schaltungsanordnung nach Anspruch 2, **dadurch gekennzeichnet, dass** die Auswerteanordnung (Ed) eine die positiven Spannungshalbwellen der betreffenden Wechselspannung auswertende erste Auswerteeinrichtung (Op1) und eine die negativen Spannungshalbwellen der betreffenden Wechselspannung auswertende zweite Auswerteeinrichtung (Op2) aufweist.

4. Schaltungsanordnung nach Anspruch 3, **dadurch gekennzeichnet, dass** jede der beiden Auswerteeinrichtungen (Op1, Op2) durch einen Operationsverstärker (Op1, Op2) gebildet ist, der mit seinem invertierenden Eingang (-) und mit seinem nichtinvertierenden Eingang (+) an den beiden Enden des genannten niederohmigen Messwiderstands (Rm) angeschlossen ist.

5. Schaltungsanordnung nach Anspruch 4, **dadurch gekennzeichnet, dass** ein erster Operationsverstärker (Op1) mit seinem nichtinvertierenden Eingang (+) und ein zweiter Operationsverstärker (Op2) mit seinem invertierenden Eingang (-) mit dem einen Ende des genannten Messwiderstands (Rm) verbunden sind und dass der genannte erste Operationsverstärker (Op1) mit seinem invertierenden Eingang (-) und der genannte zweite Operationsverstärker (Op2) mit seinem nichtinvertierenden Eingang (+) mit dem anderen Ende des genannten Messwiderstands (Rm) verbunden sind.

6. Schaltungsanordnung nach Anspruch 4 oder 5, **dadurch gekennzeichnet, dass** mit den Ausgängen der beiden Operationsverstärker (Op1, Op2) eine Auswerteschaltung (Ec) verbunden ist, welche die von den beiden Operationsverstärkern (Op1, Op2) jeweils abgegebenen Ausgangssignale mit festgelegten Schwellwertspannungen vergleicht und welche in Abhängigkeit von der Größe des Über- oder Unterschreitens der genannten festgelegten Schwellwertspannungen durch die von den betreffenden Operationsverstärkern (Op1, Op2) jeweils gegebenen Ausgangsspannungen Meldesignale abgibt, die entweder einen ordnungsgemäßen Stromfluss oder einen gestörten Stromfluss durch den jeweiligen elektrischen Verbraucher (R1, R2) und den mit diesem verbundenen gesteuerten Halbleiterschalter (T1, T2) anzeigen.

## Claims

1. Method for monitoring the functioning of one or more load circuits, particularly of a domestic appliance, which each include a controllable semiconductor switch, particularly a triac, and an electrical load connected therewith and which are supplied with power from at least one alternating voltage source, which supplies an alternating voltage with positive and negative voltage half waves, **characterised in that** the alternating currents flowing through all controllable semiconductor switches (T1, T2) and electrical loads (R1, R2) are conducted through a common low-impedance measuring resistor (Rm) and that the alternating voltage drop respectively arising at this low-impedance measuring resistor (Rm) is separately evaluated with respect to the amplitudes of the positive and negative alternating voltage half waves.

2. Circuit arrangement for performance of the method according to claim 1, particularly for a domestic appliance, wherein the circuit arrangement
- comprises one or more load circuits, which each include a controllable semiconductor switch, particularly a triac, and an electrical load connected therewith, and
wherein the circuit arrangement
- comprises at least one alternating voltage source for supply of the load circuits, wherein the alternating voltage source supplies an alternating voltage with positive and negative voltage half waves,
**characterised in that** the circuit arrangement comprises a common low-impedance measuring resistor (Rm) by way of which the electrical loads (R1, R2) together with their associated controllable semiconductor switches (T1, T2) are connected with the at least one alternating voltage source (Vac), wherein the circuit arrangement also comprises an evaluating arrangement (Ed) which is connected with the common low-impedance measuring resistor (Rm) and which is constructed for the purpose of separately evaluating the amplitudes of the positive and negative voltage half waves of an alternating voltage drop at the measuring resistor (Rm).

3. Circuit arrangement according to claim 2, **characterised in that** the evaluating arrangement (Ed) comprises a first evaluating device (Op1) evaluating the positive voltage half waves of the respective alternating voltage and a second evaluating device (Op2) evaluating the negative voltage half waves of the respective alternating voltage.

4. Circuit arrangement according to claim 3, **characterised in that** each of the two evaluating devices (Op1, Op2) is formed by an operational amplifier (Op1, Op2) which is connected by the inverting input (-) thereof and the non-inverting input (+) thereof with the two ends of the said low-impedance measuring resistor (Rm).

5. Circuit arrangement according to claim 4, **characterised in that** a first operational amplifier (Op1) is connected by the non-inverting input (+) thereof and a second operational amplifier (Op2) by the inverting input (-) thereof with one end of the said measuring resistor (Rm) and the said first operational amplifier (Op1) is connected by the inverting input (-) thereof and the said second operational amplifier (Op2) by the non-inverting input (+) thereof with the other end of the said measuring resistor (Rm).

6. Circuit arrangement according to claim 4 or 5, **characterised in that** connected with the outputs of the two operational amplifiers (Op1, Op2) is an evaluating circuit (Ec) which compares the output signals respectively issued by the two operational amplifiers (Op1, Op2) with fixed threshold value voltages and which in dependence on the amount of exceeding or falling below of the said fixed threshold value voltages by the output voltages respectively given by the relevant operational amplifiers (Op1, Op2) delivers report signals which indicate either a correct current flow or a disturbed current flow through the respective electrical load (R1, R2) and the controlled semiconductor switch (T1, T2) connected therewith.

## Revendications

1. Procédé de contrôle du mode de fonctionnement d'un ou de plusieurs circuits utilisateurs, notamment d'un appareil ménager, qui contiennent respectivement un commutateur à semi-conducteur commandable, notamment un triac, et un consommateur électrique raccordé à celui-ci, et qui sont alimentés par au moins une source de tension alternative, laquelle fournit une tension alternative à demi-ondes de tension positives et négatives, **caractérisé en ce que** les courants alternatifs traversant tous les commutateurs à semi-conducteurs commandables (T1, T2) et tous les consommateurs électriques (R1, R2) sont guidés à travers une résistance de mesure commune (Rm) de faible impédance et **en ce que** la chute de tension alternative se produisant respectivement sur cette résistance de mesure (Rm) de faible impédance est évaluée séparément en ce qui concerne les amplitudes des demi-ondes de tension alternative positives et négatives.

2. Circuit pour la réalisation du procédé selon la revendication 1, notamment pour un appareil ménager, le circuit présentant
- un ou plusieurs circuits utilisateurs qui contiennent respectivement un commutateur à semi-conducteur commandable, notamment un triac, et un consommateur électrique raccordé à celui-ci, et le circuit présentant
- au moins une source de tension alternative pour alimenter les circuits utilisateurs, la source de tension alternative fournissant une tension alternative à demi-ondes de tension positives et négatives,
**caractérisé en ce que**
le circuit présente une résistance de mesure commune (Rm) de faible impédance, par l'intermédiaire de laquelle les consommateurs électriques (R1, R2), avec leurs commutateurs à semi-conducteurs commandables correspondants (T1, T2), sont raccordés à l'au moins une source de tension alternative (Vac), le circuit présentant également un agencement d'évaluation (Ed) qui est raccordé à la résistance de mesure commune (Rm) de faible impédance et qui est réalisé pour évaluer séparément les amplitudes des demi-ondes de tension positives et négatives d'une chute de tension alternative sur la résistance de mesure (Rm).

3. Circuit selon la revendication 2, **caractérisé en ce que** l'agencement d'évaluation (Ed) présente un premier dispositif d'évaluation (Op1) évaluant les demi-ondes de tension positives de la tension alternative concernée et un second dispositif d'évaluation (Op2) évaluant les demi-ondes de tension négatives de la tension alternative concernée.

4. Circuit selon la revendication 3, **caractérisé en ce que** chacun des deux dispositifs d'évaluation (Op1, Op2) est formé par un amplificateur opérationnel (Op1, Op2) qui est raccordé aux deux extrémités de ladite résistance de mesure (Rm) de faible impédance avec son entrée inverseuse (-) et avec son entrée non-inverseuse (+).

5. Circuit selon la revendication 4, **caractérisé en ce qu'**un premier amplificateur opérationnel (Op1), avec son entrée non-inverseuse (+), et un second amplificateur opérationnel (Op2), avec son entrée inverseuse (-), sont raccordés à l'une des extrémités de ladite résistance de mesure (Rm) de faible impédance et **en ce que** ledit premier amplificateur opérationnel (Op1), avec son entrée inverseuse (-), et ledit second amplificateur opérationnel (Op2), avec son entrée non-inverseuse (+), sont raccordés à l'autre extrémité de ladite résistance de mesure (Rm).

6. Circuit selon la revendication 4 ou 5, **caractérisé en ce qu'**un circuit d'évaluation (Ec) est raccordé aux sorties des deux amplificateurs opérationnels (Op1, Op2), lequel circuit d'évaluation compare les signaux de sortie respectivement délivrés par les deux amplificateurs opérationnels (Op1, Op2) avec des tensions de valeur seuil déterminées et lequel, en fonction de la grandeur du dépassement ou du dépassement vers le bas des dites tensions de valeur seuil déterminées par les tensions de sortie respectivement données par les amplificateurs opérationnels concernés (Op1, Op2), délivre des signaux de signalisation qui indiquent soit un flux de courant correct soit un flux de courant défaillant à travers le consommateur électrique respectif (R1, R2) et le commutateur à semi-conducteur (T1, T2) commandé, raccordé à celui-ci.
